# EUROPEAN PATENT APPLICATION

(11) **EP 4 819 447 A2**
(43) Date of publication of application: **07.10.2026**
(21) Application number: 26190966.7
(22) Date of filing: 09.11.2022
(51) Int. Cl.: H02K 1/2798

(54) **ELECTRIC PUMP WITH PRINTED CIRCUIT BOARD STATOR**

(30) Priority: 09.11.2021 US 202163263786 P; 19.07.2022 US 202263368806 P
(62) Document number(s) of the earlier application(s) in accordance with Art. 76 EPC: 22891240.8 / 4 430 925
(71) Applicant: Litens Automotive Partnership, Woodbridge, Ontario L4L 5T7 (CA)
(72) Inventor: Porat, Alexander, Thornhill, L4J 7S2 (CA); Ryeland, Geoffrey William, Woodbridge, L4L 5T7 (CA); Viola, Matthew, Woodbridge, L4L 5T7 (CA); Soleimani, Javad, Woodbridge, L4L 5T7 (CA)
(74) Representative: Grünecker Patent- und Rechtsanwälte PartG mbB

(57) **Abstract**

The present invention relates to an electric pump comprising a housing which defines a fluid inlet, a fluid outlet and a pumping chamber fluidly connected to the inlet and outlet. An impeller is mounted for rotation in the pumping chamber, wherein, in operation, the impeller conveys fluid to the outlet from the inlet. A printed circuit board is disposed in the pumping chamber adjacent the impeller, the printed circuit board carrying windings for an electric stator and having a front face and a rear face, the front face opposing the impeller and the rear face opposing the front face. At least one permanent magnet structure is fixed relative to the impeller and disposed to oppose the printed circuit board windings. The at least one permanent magnet structure is immersed in the fluid being pumped and the printed circuit board is immersed in the fluid being pumped such that the front face and the rear face of the printed circuit board are in contact with the fluid being pumped.

## Description

### FIELD OF THE DISCLOSURE

The disclosure generally relates to the field of electrical machines, and more particularly to the field of electric machines that utilize a printed circuit board as a stator element.

### BACKGROUND

It is known to use a printed circuit board (PCB) to contain the windings that form the stator of an electric machine. The major problem in using such a structure is that the PCB is conventionally constructed from fiberglass, which is generally not a good thermal conductor. Thus, the heat dissipation of the PCB stator can be a limiting factor in the performance of the electric motor, particularly where the PCB is multi-layered, relegating PCB-based electrical machines to relatively low power or low duty cycle applications.

In some applications, such as for a vehicular water pump, physical size and electrical performance are important commercial factors in that it is desirable for the water pump to be as small and as light as possible, without comprising on the required power output, efficiency, or reliability.

### SUMMARY

In a first aspect, the invention provides an electric pump having a substantially planar PCB stator that is cooled on both sides thereof by the fluid being pumped.

According to the first aspect, the pump includes a housing which defines a fluid inlet, a fluid outlet and a pumping chamber fluidly connected to the inlet and outlet. An impeller is mounted for rotation in the pumping chamber, wherein, in operation, the impeller conveys fluid to the outlet from the inlet. A printed circuit board (PCB) is disposed in the pumping chamber adjacent the impeller, the PCB carrying windings for an electric stator and having a front face and a rear face, the front face opposing the impeller and the rear face opposing the front face. The front face and rear face of the PCB are in fluide communication with the fluid being pumped. At least one permanent magnet structure is fixed relative to the impeller and disposed to oppose the PCB stator windings.

The impeller can include a shaft and the at least one permanent magnet structure can be fixed to the shaft. First and second permanent magnet structures can be fixed relative to the impeller, the first permanent magnet structure can be disposed opposite the PCB front face and the second permanent magnet structure can be disposed opposite the PCB rear face. The impeller can include a shaft and the first and second permanent magnet structures can be fixed to the shaft.

In a second aspect, the invention provides an electric pump having a substantially planar PCB stator that is cooled on both sides thereof by the fluid being pumped via a leakage current induced in the pump.

According to the second aspect, the pump includes a housing which defines a fluid inlet, a fluid outlet and a pumping chamber fluidly connected to the inlet and outlet. An impeller is mounted for rotation in the pumping chamber, wherein, in operation, the impeller conveys fluid to the outlet from the inlet. A printed circuit board (PCB) is disposed in the pumping chamber adjacent the impeller, the PCB carrying windings for an electric stator and having a front face and a rear face, the front face opposing the impeller and the rear face opposing the front face. At least one permanent magnet structure is fixed relative to the impeller and disposed to oppose the PCB stator windings. Means are provided for enabling a fluid leakage current arising from a pressure differential in the pumping chamber to flow across the PCB front and rear faces.

The means for enabling a fluid leakage current can include at least one passageway formed in at least one of the permanent magnet structure and the impeller which fluidly communicates the front and rear faces of the PCB with the pumping chamber at a first radial position proximate to a rotational axis defined by the impeller, and at least one passageway formed in at least one of the housing or the PCB that fluidly communicates the front and rear faces of the PCB with the pumping chamber at a second radial position that is larger than the first radial position. The impeller can have centrifugal-style vanes which generate a radially orientated fluid pressure differential when the impeller is operative to pump fluid.

The impeller can include a radially projecting flange and a through-hole can be formed in the flange. The impeller can also include a shaft and a through-hole can be formed in the shaft.

In a third aspect, the invention provides a PCB stator for a pump.

According to the third aspect, the PCB stator is a multi-layered board carrying PCB windings which comprise a circumferential sequence of radially-orientated spokes, each spoke being formed from overlapping radially orientated traces in the PCB layers, wherein the overlapping traces are interconnected via at least two straight vias at opposing ends of the radially orientated traces, thereby enabling heat generated in internal PCB layers to be thermally conducted to outermost PCB layers.

Each spoke can be wedge-shaped, having a width at an outer radial end larger than a width at an inner radial end.

The PCB windings can include a common repeating coil pattern comprising a first coil formed of n odd sequential spokes connected through inner and outer circumferential traces to n-1 sequential spokes disposed at a distance of pole pitch P such that the first coil is wound in a first winding direction, coupled to a second adjacent coil formed of n odd sequential spokes connected through inner and outer circumferential traces to n-1 sequential spokes disposed at a distance of pole pitch P such that the second coil is wound in a second winding direction, opposite the first winding direction.

### BRIEF DESCRIPTION OF THE DRAWINGS

The foregoing and other aspects of the invention will now be described in greater detail, by way of example only, with reference to the attached drawings, in which:
Figure 1 is a perspective view of a water pump;
Figure 2 is a cross-sectional view of the pump shown in Figure 1 taken along line Il-Il;
Figure 3A is an exploded view of the pump shown in Figure 1 ;
Figure 3B is an exploded view of the pump shown in Figure 3A, taken along a direction of view opposite to that of Figure 3A;
Figure 4A is a perspective view of a pump chamber defined by the front housing;
Figure 4B is a detail cross-sectional diagram illustrating pressure differential across an impeller used in the pump;
Figure 4C is a detail cross-sectional diagram illustrating pump internal leakage currents;
Figure 4D is a detail cross-sectional diagram illustrating leakage current around a printed circuit board mounted in the pump;
Figures 4E - 4J are cross-sectional views of first through sixth alternate embodiments of the pump;
Figure 5A is a cross-section view of a multi-phase stator winding applied to the printed circuit board;
Figure 5B is a diagram of a repeating common stator coil pattern;
Figure 5C is a diagram of a single-phase winding applied to a layer of the printed circuit board; and
Figures 5D - 5F are diagrams of transitional windings on various PCB layers.

### DETAILED DESCRIPTION OF EXAMPLE EMBODIMENTS

For simplicity and clarity of illustration, where considered appropriate, reference numerals may be repeated among the Figures to indicate corresponding or analogous elements. In addition, numerous specific details are set forth in order to provide a thorough understanding of the embodiment or embodiments described herein. However, it will be understood by those of ordinary skill in the art that the embodiments described herein may be practiced without these specific details. In other instances, well-known methods, procedures and components have not been described in detail so as not to obscure the embodiments described herein. It should be understood at the outset that, although exemplary embodiments are illustrated in the figures and described below, the principles of the present disclosure may be implemented using any number of techniques, whether currently known or not. The present disclosure should in no way be limited to the exemplary implementations and techniques illustrated in the drawings and described below.

Various terms used throughout the present description may be read and understood as follows, unless the context indicates otherwise: "or" as used throughout is inclusive, as though written "and/or"; singular articles and pronouns as used throughout include their plural forms, and vice versa; similarly, gendered pronouns include their counterpart pronouns so that pronouns should not be understood as limiting anything described herein to use, implementation, performance, etc. by a single gender; "exemplary" should be understood as "illustrative" or "exemplifying" and not necessarily as "preferred" over other embodiments. Further definitions for terms may be set out herein; these may apply to prior and subsequent instances of those terms, as will be understood from a reading of the present description.

Modifications, additions, or omissions may be made to the systems, apparatuses, and methods described herein without departing from the scope of the disclosure. For example, the components of the systems and apparatuses may be integrated or separated. Moreover, the operations of the systems and apparatuses disclosed herein may be performed by more, fewer, or other components and the methods described may include more, fewer, or other steps. Additionally, steps may be performed in any suitable order. As used in this document, "each" refers to each member of a set or each member of a subset of a set.

The indefinite article "a" is not intended to be limited to mean "one" of an element. It is intended to mean "one or more" of an element, where applicable, (i.e. unless in the context it would be obvious that only one of the element would be suitable).

Any reference to upper, lower, top, bottom or the like are intended to refer to a relative orientation of a particular element in relation to other elements and not necessarily in absolute terms, or to orientation during manufacture, shipping or use. The upper surface of an element, for example, can still be considered an upper surface in relation to another surface even when the element is lying on its side or upside down.

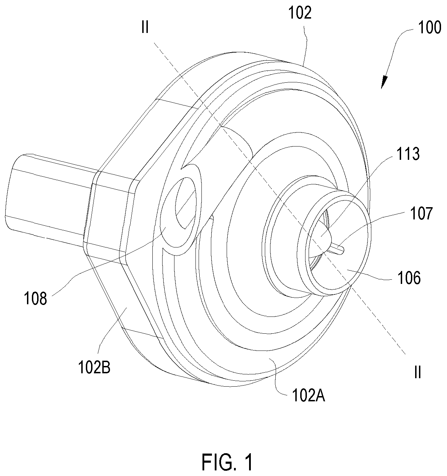

Figures 1-4D show an electric water pump 100 in perspective view in accordance with one embodiment, it being understood that other embodiments are possible within the scope of the appended claims.

As seen in Figure 1, the illustrated pump 100 includes an outer casing 102, having a first casing half 102A and a second casing half 102B that are sealingly interconnected, for example, via ultrasonic welding if the casing halves 102A, 102B are molded from thermoplastics.

The first casing half 102A can be formed with an axial inlet 106 for the ingress of fluid and a circumferential outlet 108 for the egress of fluid.

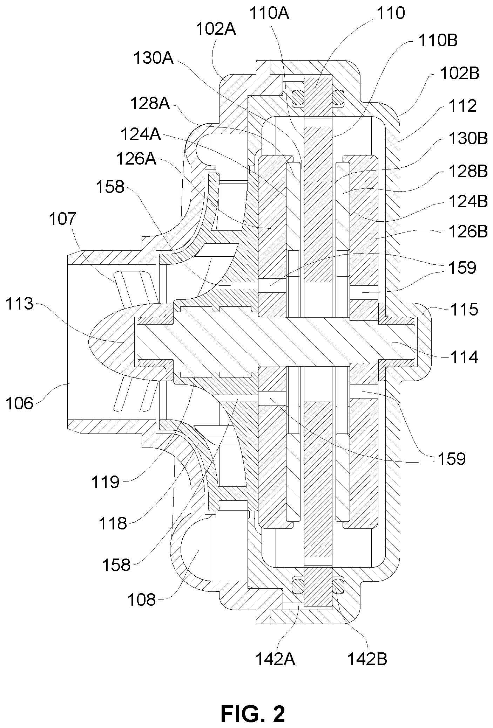

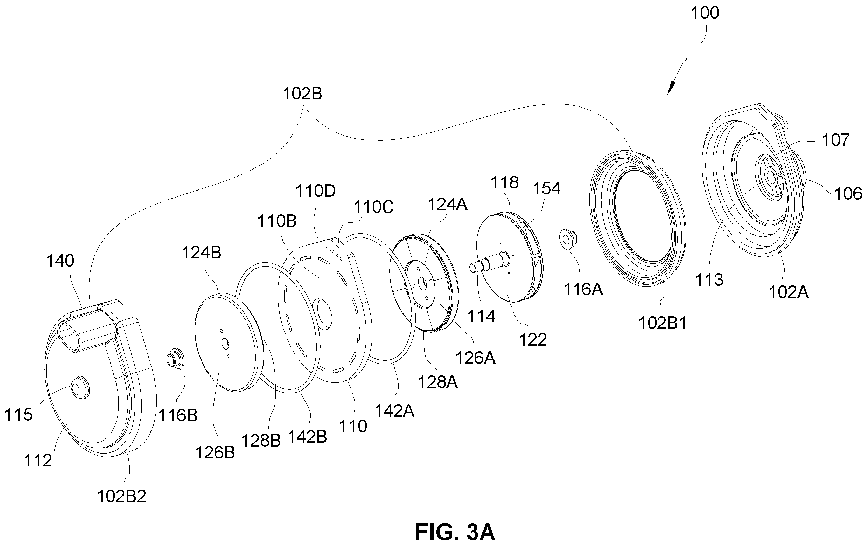

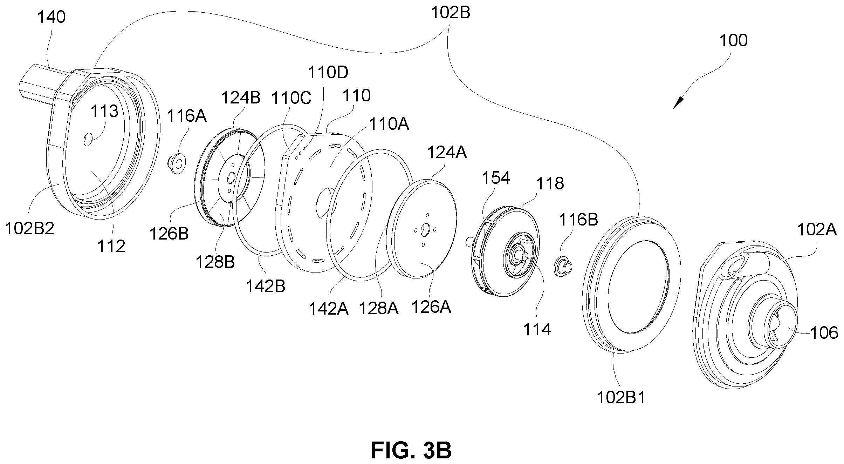

Referring additionally to Figure 2, which shows a cross-sectional view of the pump 100, and Figures 3A and 3B, which show exploded views of the pump 100, the second casing half 102B can be formed from a first part 102B1 and a second part 102B2 which sandwich a printed circuit board (PCB) 110 and constrain other components of the pump 100.

A shaft or spindle 114 mounted for rotation within the casing 102 defines a rotational axis of the pump 100. More particularly, the first casing half 102A can include an integrally formed hub 113 within the inlet 106, with the hub 113 being supported in the inlet 106 by integrally formed struts 107. The second casing half 102B can include an axial wall 112 with an integrally formed hub 115. A first thrust bearing or bushing 116A and a second thrust bearing or bushing 116B can be installed within the hubs 113, 115 for journaling the spindle 114.

An impeller 118 can be fixed to the spindle 114, for example, via a splined interconnection 119 (seen best in Figure 2).

At least one permanent magnet structure 124 can be fixed relative to the impeller 118.

The illustrated embodiment has two permanent magnet structures 124A, 124B, located on opposite sides of the PCB 110, that are fixed relative to the impeller 118. In alternative embodiments, one of these structures can be omitted although that may not be optimal from a performance perspective, depending on the application.

Permanent magnet structure 124A can be mechanically fastened to a rear flange portion 122 of the impeller 118 or press-fit onto the shaft 114, as shown, to maintain a fixed relationship between the permanent magnet structure 124A and the impeller 118. The permanent magnet structure 124A can comprise a back-iron disc 126A and a permanent magnet disc 128A adhered thereto, which disc 128A can be segmented circumferentially into magnets of alternating pole faces, as indicated by stippled lines. The permanent magnet structure 124A faces a front side 110A of the PCB 110 through a front air gap 130A (see Figure 2).

Permanent magnet structure 124B can be press-fit onto the spindle 114, as shown, to maintain a fixed relationship between the permanent magnet structure 124B and the impeller 118. The permanent magnet structure 124B can comprise a back-iron disc 126B and a permanent magnet disc 128B, which disc 128B can be segmented circumferentially into magnets of alternating pole faces, as indicated by stippled lines. The permanent magnet structure 128B faces a rear side 110B of the PCB 110 through a rear air gap 130B (see Figure 2).

As described in greater detail below, the PCB 110 carries electrical windings so as to function as a stator for the electric water pump 100. With the permanent magnet structures 124A and 124B being fixed relative to the impeller 118 and straddling the PCB 110, the impeller 118 thus forms part of a rotor for an electric machine realized by the water pump 100.

The PCB 110 can include a projecting section or tail 110C which can include terminals 110D that face a wiring connector portion 140 incorporated in the second casing half 102B so as to enable the application of phase currents to the PCB stator windings. Gaskets 142A, 142B can be provided for fluid sealing purposes.

It is desirable to make the electric water pump 100 small and compact relative to its power output. For example, in one embodiment a one-hundred-Watt (mechanical) pump can have a diameter of around 70 - 90 mm and axial length of about 30 - 40 mm, inclusive of the impeller. To achieve such performance the PCB 110 is preferably multi-layered to carry multiple windings stacked in various layers of the PCB. For example, in one embodiment the PCB 110 can be a six-layer board with windings composed from 6oz copper traces. In another embodiment, the PCB 110 can be a twelve-layer board with windings composed of 3 oz copper traces. Many other permutations and combinations are possible. Regardless, in operation the PCB 100 can generate a substantial amount of heat that must be managed in order to keep the PCB 110, which is desired to be formed from conventional FR-4 fiberglass, within its allowable maximum temperature limit of about 130-140 degrees C. The problem is compounded in automotive applications by the fact that the environment can itself be relatively hot as the pump must be able operate in hot ambient temperatures of up to 60 degrees C and in a fluid environment that can reach 90 degree C temperatures. In view of these factors, the allowable temperature rise of the PCB 110 is limited to about 110-120 degrees C at the maximum operating envelope for automotive applications.

In order to achieve a relatively low temperature rise, the PCB 110 can be immersed in the fluid to be pumped such that both faces of the PCB 110 are in contact with the fluid and each PCB face 110A, 110B is optionally exposed to a suitable fluid flow thereacross. The fluid may be water, glycol, or other such fluids used in a heat exchange loop. In alternative applications, the fluid may also be oil or a dielectric fluid, for example, for use in immersion cooling of battery pack cells.

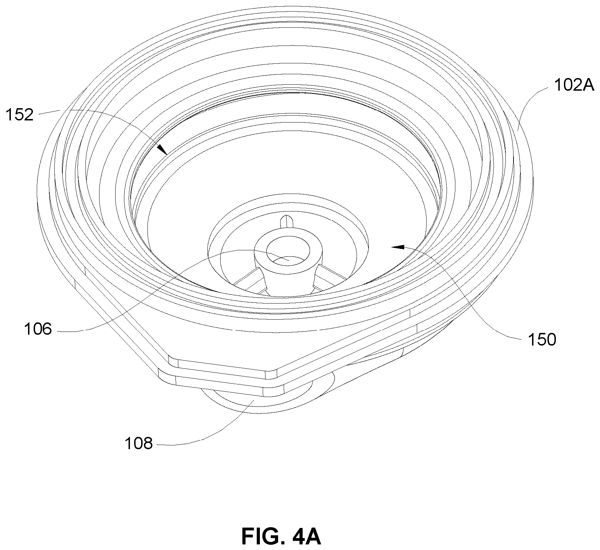

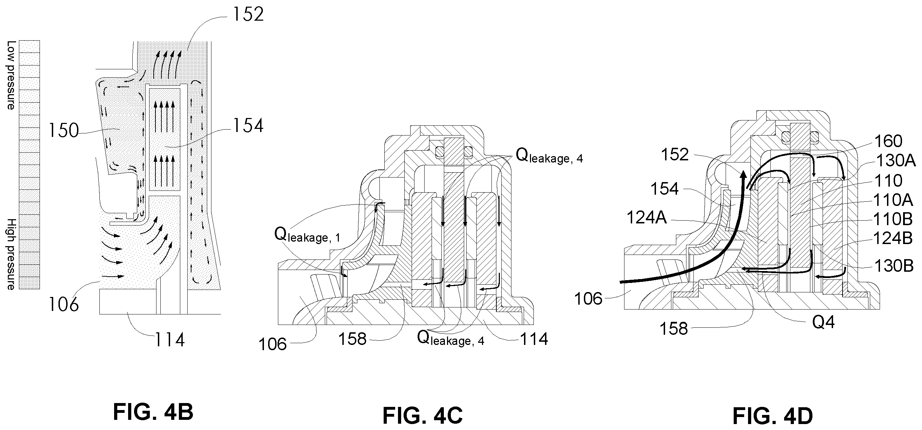

More particularly, and referring additionally to Figure 4A, the impeller 118 is seated in a pumping chamber 150 which includes the inlet 106 located about the pump axis of rotation and a circumferentially located volute 152 which smoothly increases in cross section toward the outlet 108, the volute 152 being located radially outward of the inlet 106. The impeller 118 has centrifugal style vanes 154 that are shaped as known in the art to induce fluid flow centrifugally, commencing axially from the inlet 106 and terminating radially into the volute 152. Referring additionally to the detailed cross-sectional diagram of Figure 4B, which illustrates pressure differential in the pumping chamber 150, the centrifugal nature of the impeller 118 can induce a fluid pressure differential extending radially across the pumping chamber, with fluid pressure being relatively low near the central axis and generally increasing in pressure in the increasing radial direction. Referring additionally to the detailed cross-sectional diagram of Figure 4C, the pressure differential can induce front and rear leakage currents QI and Q4, respectively. In the front leakage current QI fluid can flow from the volute 152 back to the inlet 106 across the front of the impeller 118. The rear leakage current Q4 can be enabled by one or more through-holes 158 formed in the impeller 118, through-holes 159 formed in the back-iron discs 126A, 126B, and a series of through-holes 160 in the PCB 110. These passageways allow a current to flow from the volute 152 to the inlet 106 behind the rear flange portion 122 of the impeller 118. In the illustrated embodiment the PCB 110 is disposed to the rear of the impeller 118 such that, referring additionally to the cross-sectional view of Figure 4D, the rear leakage current Q4 can flow through the front air gap 130A across the front side 110A of the PCB 110. The PCB through-holes 160 allow the rear leakage current Q4 to also flow through the rear air gap 130B across the rear side 110B of the PCB 110.

The number, size and total cross-sectional area of the impeller through-holes 158, disc through-holes 159, and the PCB through-holes 160 can be tuned for any particular application to achieve desired leakage current flow rates.

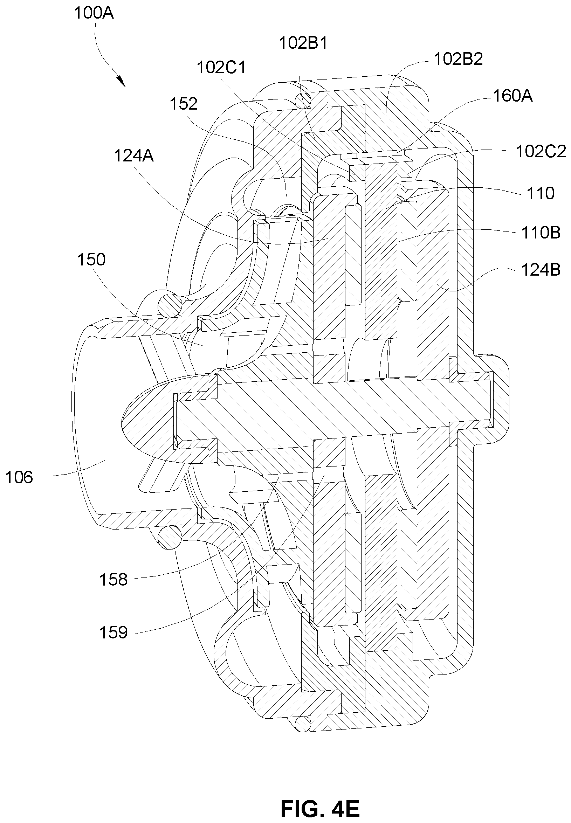

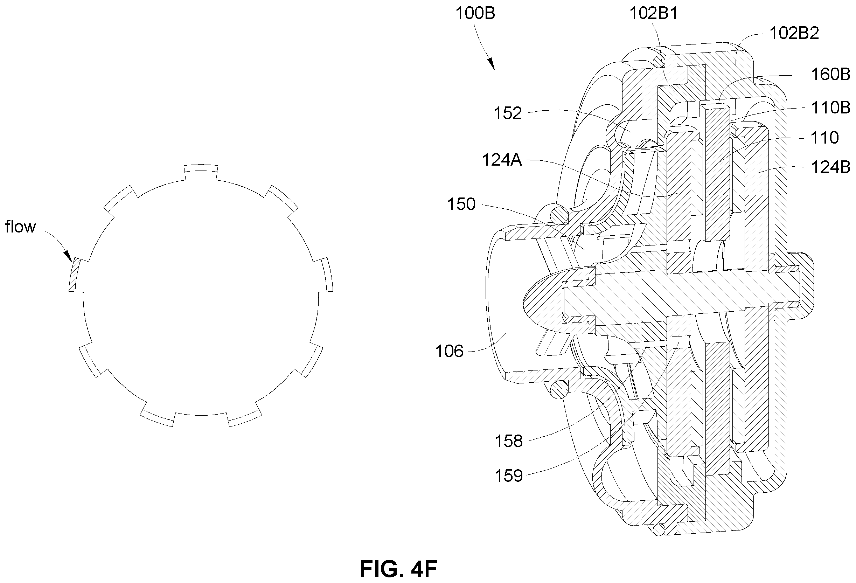

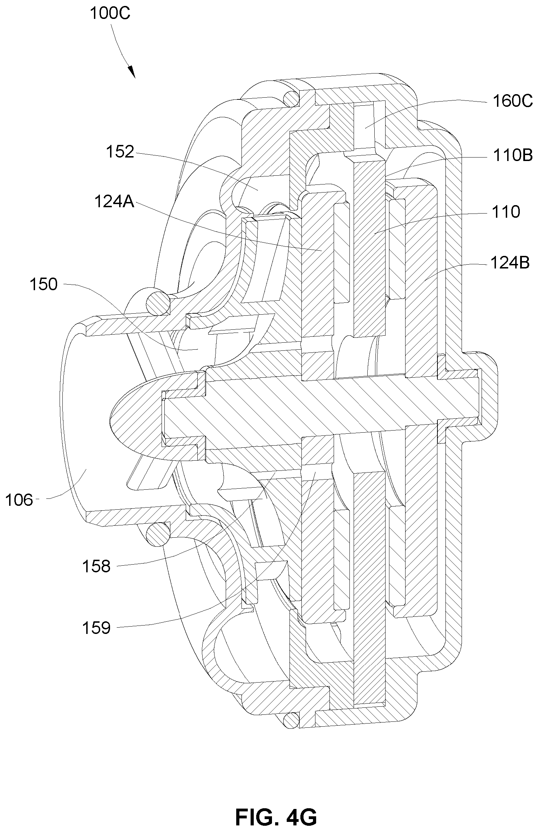

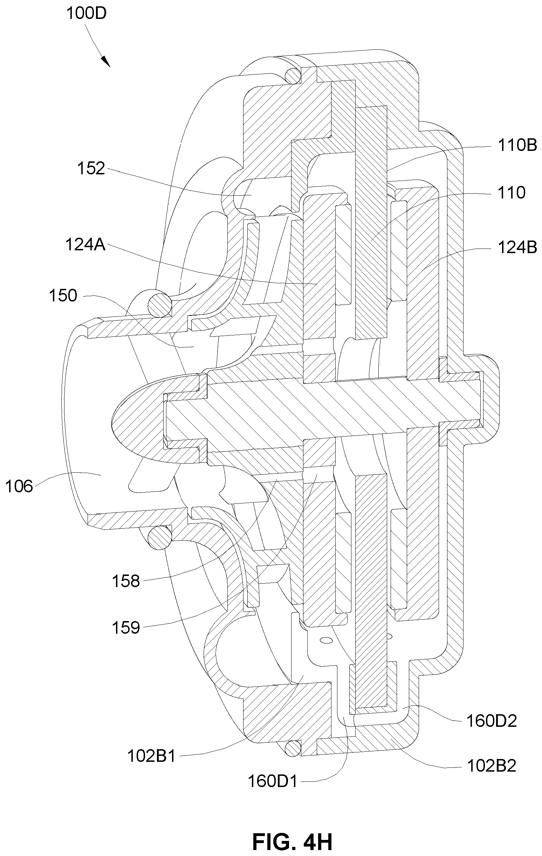

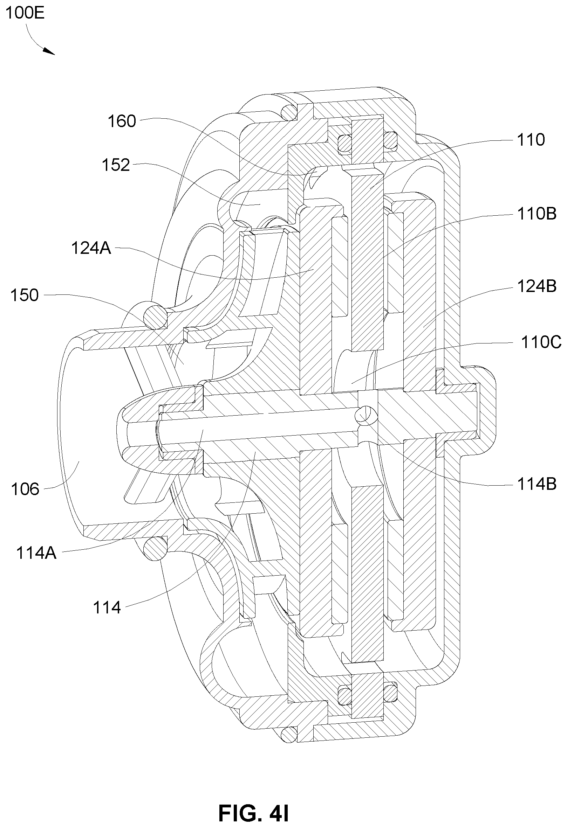

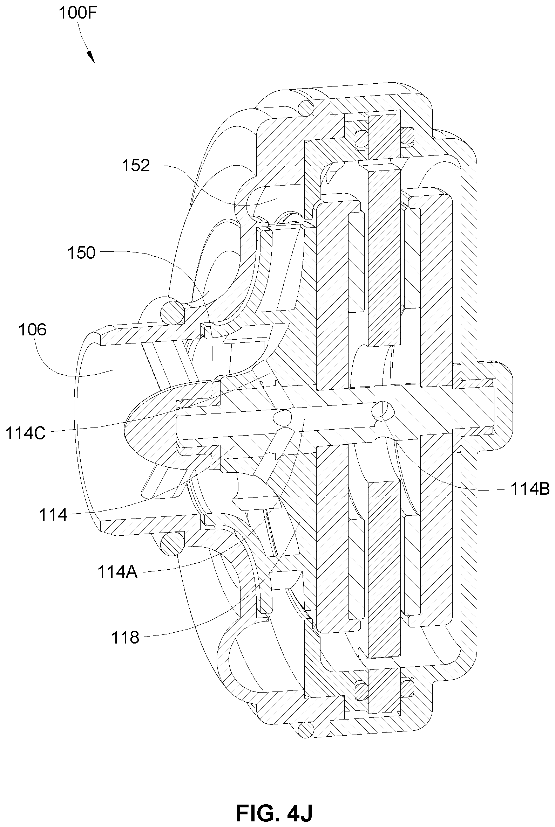

It should be appreciated that while the illustrated embodiment has shown one structure to implement a means for enabling a fluid leakage current arising from a pressure differential in the pumping chamber to flow across the PCB front and rear faces 11 OA, 11 OB, alternate embodiments can embody other structures to achieve this function. For example. Figure 4E shows a cross-sectional view of an alternate pump 10OA in which the casing parts 102B1 and 102B2 feature radially inwardly projecting rings 102C1 and 102C2 for clamping the PCB 110, with the rings 102C1, 102C2 having passageways 160A formed therein for allowing leakage current arising from the pressure differential in the pumping chamber 150 to flow to the rear face 11 OB of the PCB 110. As another example. Figure 4F shows a cross-sectional view of another pump 100B with cut-outs 160B in the casing parts 102B1, 102B2. As another example. Figure 4G shows a cross-sectional view of another pump 100C in which the PCB 110 has a tooth-shaped outer periphery, with valleys 160C in the PCB functioning as fluid passageways. As another example. Figure 4H shows a cross-sectional view of another pump 100D in which the casing parts 102B1 and 102B2 include passageways 160D1, 160D2 for enabling fluid to flow to the rear face 110B of the PCB 110. As another example. Figure 4I shows a cross-sectional view of another pump 100E in which the through-holes 158, 159 are omitted and replaced by an axial passageway 114A formed in the spindle 114. In this embodiment, the spindle 114 also features a hole 114B disposed in PCB central opening HOC for enabling fluid flow through the passageway 114A and thus enabling fluid to flow across the front and rear faces 110A, 110B of the PCB 110. As another example. Figure 4J shows a cross-sectional view of another pump 100F that is a variant of pump 100E. In pump 100F, the spindle passageway 114A is blocked at the forward end and side passageways 114C through the spindle 114 and impeller 118 provide fluid communication to the inlet 106. It will be further appreciated that the structures of the foregoing embodiments may be further mixed and matched to provide yet additional alternatives to embodying a means for enabling a fluid leakage current arising from a pressure differential in the pumping chamber to flow across the PCB front and rear faces 110A, HOB.

In some embodiments a water impervious membrane can be applied to the PCB 110. For example, the PCB 110 can be sprayed with a water-impervious coating such as an epoxy or polymer, e.g., parylene, to prevent direct contact with the PCB. Overmolding the PCB with resin is also possible, subject to the limitation that the thickness of the coating adds to the size of the magnetic circuit air gap, which has a practical upper bound of no more than a few millimeters. Likewise, it may be desirable to have the windings printed on inner layers of the PCB with the outermost front and rear PCB layers, being of fiberglass, functioning as the water impervious membrane. In such embodiments, a water impervious coating can be applied to only the circumferential extent of the PCB, with optionally

The fluid being pumped can be cooled through conventional heat exchangers, such as through a radiator as for example in automotive applications. In certain applications, dedicated heat exchangers may be omitted and the housing and conduits in which the fluid is carried may function as the heat exchange mechanism to the ambient environment.

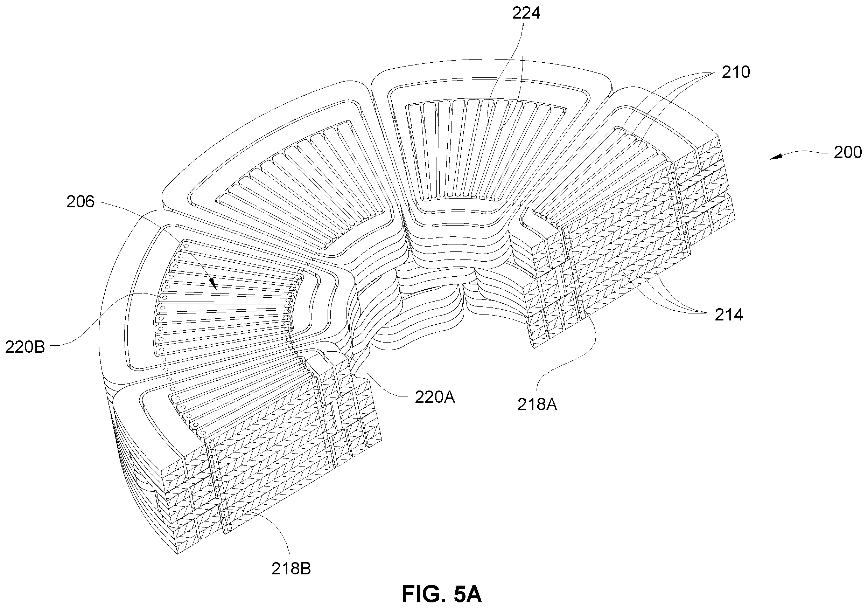

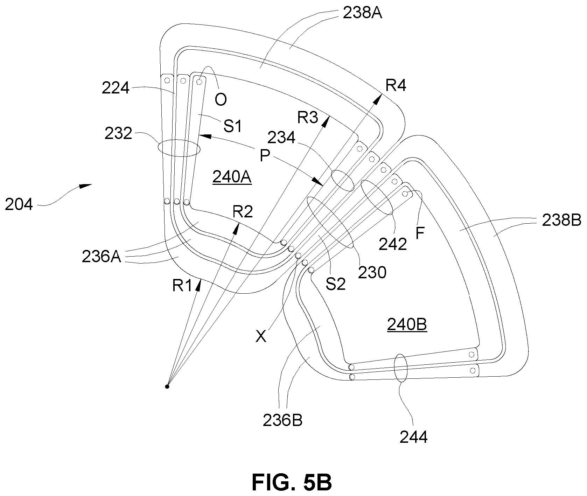

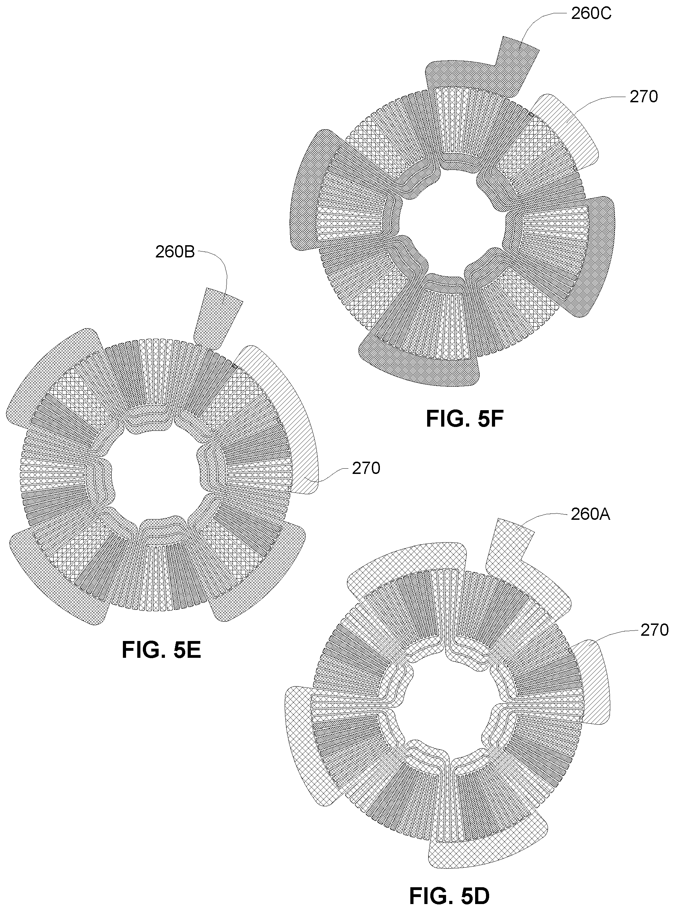

As mentioned above, a variety of PCB stator winding patterns and corresponding permanent magnet patterns can be used to implement the electrical motor design. To achieve a relatively high degree of power density, it is generally desirable to employ a multi-layer PCB board as there is typically a practical limit on how thick and/or wide the copper traces can be. Conversely, the more layers the PCB board has the more heat can be trapped therein. To handle these competing factors, the illustrated embodiment can employ a stator winding design in which all layers of the PCB are electrically coupled together by straight vias, avoiding any blind or buried vias, so that heat can flow from the internal layers to the external layers. Referring more particularly to Figure 5A, which shows a cross section of a stator winding pattern 200, and Figure 5B, which shows an example of a common repeating coil pattern 204, it will be seen that an active area 206 of the stator, which is mated to the permanent magnet structure(s), can be confined to the toroidal area defined by radii R2 - R3. In the active area 206 a series of radial spokes 210 can be formed, each spoke 210 being formed by a stack of radially distinct traces 21OA on each of the PCB layers 214 (twelve layers being shown) that can be interconnected by straight vias 218A, 218B disposed proximate to R2 and R3, respectively. Thus, the illustrated embodiment has a first and second circumferential series 220A, 220B of straight vias, with no blind or buried vias.

Alternative embodiments may, however, employ blind or buried vias, although such arrangements tend to increase the cost of the PCB.

Each spoke 210 can be wedge-shaped, being characterized by having a larger width proximate to R3 than proximate to R2 such that the non-conductive gaps 224 between the spokes 210 have substantially the same width along the radial dimension. It has been found that such a structure can aid in reducing flux leakage.

Referring to the example common repeating coil pattern 204 of Figure 5B, it will be seen that a grouping 230 of five adjacent spokes 210 can be ganged together to enable the same direction of current flow and thus represent one 'pole'. The coil pattern 204 can be formed by starting at an origin point 0 proximate to R3 on one of the spokes SI and interconnecting a set 232 of three sequential spokes with a set 234 of two other sequential spokes disposed at a distance of a pole pitch P utilizing three inner circumferential traces 236A and two outer circumferential traces 238B to intermediate point X proximate to R2 on the next spoke S2 adjacent to the two other spoke set 234 such that a coil 240A formed thereby is wound in a first winding direction. The coil pattern 204 continues from intermediate point X, encompassing a set 242 of three sequential spokes with a set 244 of two additional other sequential spokes disposed at a distance of pole pitch P utilizing two inner circumferential traces 236B and two outer circumferential traces 238B to final point F proximate to R3 on an outermost spoke of the spoke set 242 such that a coil 240B formed thereby is wound in a second winding direction, opposite the first winding direction. Of course, the pattern could alternatively be described as commencing from point F and terminating at point 0. More generally, the winding pattern 204 can be described as a first coil comprised of n odd sequential spokes connected through inner and outer circumferential traces to n-1 sequential spokes disposed at a distance of pole pitch P such that the first coil is wound in a first winding direction, coupled to a second adjacent coil comprised of n odd sequential spokes connected through inner and outer circumferential traces to n-1 sequential spokes disposed at a distance of pole pitch P such that the second coil is wound in a second winding direction, opposite the first winding direction. Of course, the general pattern could alternatively be described in the reverse direction.

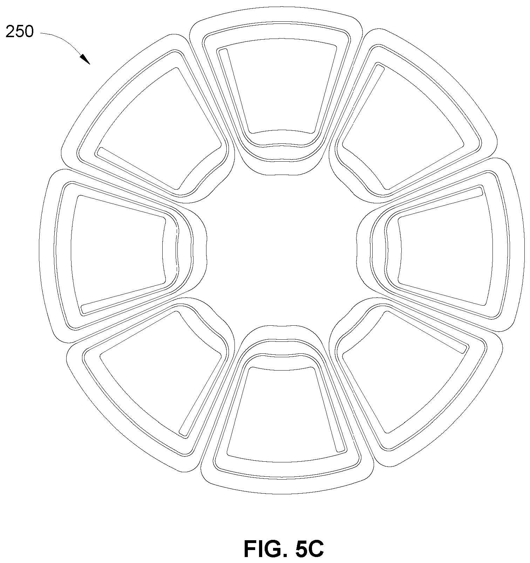

Figure 5C shows the repeating coil pattern 204 of Figure 5B extended over three hundred and sixty degrees in one PCB layer 214 to form an eight-pole single phase pattern 250. A plurality of the PCB layers 214 can be imbued with this pattern 250 in overlapping stacked relationship so that a single phase can be composed of multiple PCB layers. Likewise, the pattern 250 can be applied at offset angles to other PCB layers to provide additional electrical phases, and it will be seen from Figure 5A that the illustrated embodiment provides a twenty-four-pole stator comprising three phases, eight poles per phase, which can be mated to an eight-pole permanent magnet structure. Figures 5D - 5F show windings on transition PCB layers for the three phases, including input terminals 260A, 260B and 260C as well as common terminal 270 for connecting the three phases in a Y configuration.

The electric machine provisioned by the water pump 100 can be controlled via field orientated control (FOC) or direct torque and flux control (DTFC) techniques as known in the art per se.

Although specific constructions and advantages of the illustrated embodiment(s) have been enumerated above, persons skilled in the art will appreciate that there are yet more alternative implementations and modifications possible, and that the above examples are only illustrations of one or more implementations which may include some, none, or all of the enumerated advantages. The scope, therefore, is to be limited only by the appended claims.
The further embodiments of the present invention are as follows:
Embodiment 1. A pump, comprising:
   a housing (102), the housing defining a fluid inlet (106), a fluid outlet (108) and a pumping chamber (150) fluidly connected to the inlet and outlet;
   an impeller (118) mounted for rotation in the pumping chamber, wherein, in operation, the impeller conveys fluid to the outlet from the inlet;
   a printed circuit board (PCB) (110) disposed in the pumping chamber adjacent the impeller, the PCB carrying windings for an electric stator and having a front face (110A) and a rear face (110B), the front face opposing the impeller and the rear face opposing the front face;
   at least one permanent magnet structure (124A, 124B) fixed relative to the impeller and disposed to oppose the PCB stator windings; and
   means (152, 154, 158, 159, 160; 160A; 160B; 160C; 160D1, 160D2; 114, 114A, 114B; 114C) for enabling a fluid leakage current (QI, Q4) arising from a pressure differential in the pumping chamber to flow across the PCB front and rear faces.
Embodiment 2. The pump according to embodiment 1, wherein the impeller (118) includes a shaft (114) and the at least one permanent magnet structure (124A, 124B) is fixed to the shaft.
Embodiment 3. The pump according to embodiment 1, wherein first and second permanent magnet structures (124A, 124B) are fixed relative to the impeller, the first permanent magnet structure (124A) being disposed opposite the PCB front face (110A) and the second permanent magnet structure (124B) being disposed opposite the PCB rear face (110B).
Embodiment 4. The pump according to embodiment 3, wherein the impeller (118) includes a shaft (114) and the first and second permanent magnet structures (124A, 124B) are fixed to the shaft.
Embodiment 5. The pump according to embodiment 1, wherein the means for enabling a fluid leakage current includes:
   at least one passageway (158, 159) formed in at least one of the permanent magnet structure (124A, 124B) and the impeller (118) which fluidly communicates the front and rear faces of the PCB with the pumping chamber (150) at a first radial position proximate to a rotational axis defined by the impeller;
   at least one passageway (160,160A; 160B; 160C; 160D1, 160D2) formed in at least one of the housing or the PCB that fluidly communicates the front and rear faces of the PCB with the pumping chamber at a second radial position that is greater than the first radial position; and
   wherein the impeller (118) has centrifugal-style vanes (154) which generate a radially orientated fluid pressure differential when the impeller is operative to pump fluid.
Embodiment 6. The pump according to embodiment 5, wherein the impeller (118) incudes a radially projecting flange (122) and a through-hole (158) is formed in the flange.
Embodiment 7. The pump according to embodiment 5, wherein the impeller (118) includes a shaft (114) and a through-hole (114A, 114C) is formed in the shaft
Embodiment 8. The pump according to embodiment 1, wherein the PCB (110) is a multi-layered (214) board and the PCB windings comprise a circumferential sequence of radially-orientated spokes (210), each spoke being formed from overlapping radially orientated traces (21 OA) in the PCB layers (214), wherein the overlapping traces are interconnected via at least two straight vias (218A, 218B) at opposing ends of the radially orientated traces, thereby enabling heat generated in internal PCB layers to be thermally conducted to outermost PCB layers.
Embodiment 9. The pump according to embodiment 8, wherein each spoke (210) is wedge-shaped, having a width at an outer radial end larger than a width at an inner radial end.
Embodiment 10. The pump according to embodiment 8, wherein the PCB windings include a common repeating coil pattern (204) comprising a first coil (240A) formed of n odd sequential spokes connected through inner and outer circumferential traces to n-1 sequential spokes disposed at a distance of pole pitch P such that the first coil is wound in a first winding direction, coupled to a second adjacent coil (240B) formed of n odd sequential spokes connected through inner and outer circumferential traces to n-1 sequential spokes disposed at a distance of pole pitch P such that the second coil is wound in a second winding direction, opposite the first winding direction.
Embodiment 11. A printed circuit board (PCB) stator for a pump, comprising: a multi-layered (214) board (110) carrying windings (200) which comprise a circumferential sequence of radially-orientated spokes (210), each spoke (210) being formed from overlapping radially orientated traces (21 OA) in the PCB layers (214), wherein the overlapping traces (21 OA) are interconnected via at least two straight vias (218A, 218B) at opposing ends of the radially orientated traces, thereby enabling heat generated in internal PCB layers to be thermally conducted to outermost PCB layers.
Embodiment 12. The PCB stator according to embodiment 11, wherein each spoke (210) is wedge-shaped, having a width at an outer radial end larger than a width at an inner radial end.
Embodiment 13. The PCB stator according to embodiment 11, wherein the PCB windings include a common repeating coil pattern (204) comprising a first coil (240A) formed of n odd sequential spokes (210) connected through inner and outer circumferential traces to n-1 sequential spokes disposed at a distance of pole pitch P such that the first coil is wound in a first winding direction, coupled to a second adjacent coil (240B) formed of n odd sequential spokes (210) connected through inner and outer circumferential traces to n-1 sequential spokes disposed at a distance of pole pitch P such that the second coil is wound in a second winding direction, opposite the first winding direction.

## Claims

1. An electric pump, comprising:
a housing (102) which defines a fluid inlet (104), a fluid outlet (106) and a pumping chamber (108) fluidly connected to the inlet (104) and outlet (106);
an impeller (120) mounted for rotation in the pumping chamber (108), wherein, in operation, the impeller (120) conveys fluid to the outlet (106) from the inlet (104);
a printed circuit board (110) disposed in the pumping chamber (108) adjacent the impeller (120), the printed circuit board (110) carrying windings for an electric stator and having a front face (110A) and a rear face (110B), the front face (110A) opposing the impeller (120) and the rear face (110B) opposing the front face (110A);
at least one permanent magnet structure (124A or 124B) fixed relative to the impeller (120) and disposed to oppose the printed circuit board windings;
wherein the at least one permanent magnet structure (124A, 124B) is immersed in the fluid being pumped and the printed circuit board (110) is immersed in the fluid being pumped such that the front face (110A) and the rear face (110B) of the printed circuit board (110) are in contact with the fluid being pumped.

2. The electric pump according to claim 1, wherein first and second permanent magnet structures (124A, 124B) are fixed relative to the impeller (120), the first permanent magnet structure (124A) being disposed opposite the front face (110A) of the printed circuit board (110) and the second permanent magnet structure (124B) being disposed opposite the rear face (110B) of the printed circuit board (110).

3. The electric pump according to claim 1, wherein the impeller (120) includes a shaft (114), and the at least one permanent magnet structure (124A, 124B) is fixed to the shaft (114).

4. The electric pump according to any of claims 1 to 3, wherein each of the front face (110A) and the rear face (110B) of the printed circuit board (110) is exposed to a fluid flow thereacross.

5. The electric pump according to any one of claims 1 to 4, wherein the printed circuit board (110) is formed from FR-4 fiberglass.

6. The electric pump according to any one of claims 1 to 5, wherein the printed circuit board (110) is a multi-layered board carrying windings stacked in various layers of the printed circuit board (110).

7. The electric pump according to any one of claims 1 to 6, wherein the windings are printed on inner layers of the printed circuit board (110) and the outermost front and rear layers of the printed circuit board (110) are of fiberglass.

8. The electric pump according to claim 7, wherein no water impervious coating is applied to the outermost front and rear layers of the printed circuit board.

9. An arrangement of an electric pump according to any one of claims 1 to 8 and a fluid being pumped through the pump, wherein the fluid is water, glycol, oil or a dielectric fluid.

10. A printed circuit board stator (110) for an electric pump, the printed circuit board stator (110) carrying windings for an electric stator, wherein the windings are printed on inner layers of the printed circuit board stator (110), and wherein outermost front and rear layers of the printed circuit board stator (110) are of FR-4 fiberglass and no water impervious coating is applied to the outermost front and rear layers of the printed circuit board.

11. The printed circuit board stator (110) according to claim 10, wherein a water impervious coating is applied only to the circumferential extent of the printed circuit board stator (110).
